# FASCICULE DE BREVET EUROPEEN

(11) **EP 3 510 847 B1**
(45) Date de publication et mention de la délivrance du brevet: **23.07.2025**
(21) Numéro de dépôt: 17749735.1
(22) Date de dépôt: 10.08.2017
(51) Int. Cl.: H05K 7/20, H05K 9/00

(54) **CAPOT MONOBLOC POUR DISPOSITIF ÉLECTRONIQUE**
EINTEILIGE ABDECKUNG FÜR EINE ELEKTRONISCHE VORRICHTUNG
SINGLE-PIECE COVER FOR AN ELECTRONIC DEVICE

(30) Priorité: 08.09.2016 FR 1658372
(43) Date de publication de la demande: 17.07.2019
(73) Titulaire: Sagemcom Broadband SAS, 92270 Bois-Colombes (FR)
(72) Inventeur: SABATIER, Pierre, 92270 BOIS-COLOMBES (FR); SUSINI, Dominique, 92270 BOIS-COLOMBES (FR); ALEGRE, Thierry, 92270 BOIS-COLOMBES (FR); DEJARDIN, Romain, 92270 BOIS-COLOMBES (FR)
(74) Mandataire: Cabinet Boettcher
(86) Numéro de dépôt international: PCT/EP2017/070388
(87) Numéro de publication internationale: WO 2018/046230

(56) Documents cités:
- WO-A1-2016/002456
- FR-A1- 2 745 148
- JP-A- 2011 066 039
- JP-A- 2011 176 673
- JP-A- H11 127 010
- US-A1- 2006 215 369
- US-A1- 2014 192 508
- US-A1- 2015 257 309
- US-B1- 6 180 436
- US-B2- 10 175 728

## Description

### DOMAINE DE L'INVENTION

La présente invention concerne le domaine des dispositifs de communication électroniques sans fil et plus particulièrement les boitiers des dispositifs électroniques sans fil de type routeur ou passerelle.

### ARRIERE PLAN DE L'INVENTION

Il existe des dispositifs électroniques comportant un boîtier renfermant notamment une carte électronique électriquement reliée à une antenne, et un dissipateur thermique pour évacuer les calories produites par un ou plusieurs des composants électroniques de la carte électronique pendant son fonctionnement. La carte électronique reçoit également un écran de blindage électromagnétique et un capot de protection mécanique sur lequel sont généralement portées les finitions décoratives du dispositif. Un tel dispositif est connu par exemple du document WO-A-2016002456.

La multiplicité des sous-éléments composant le dispositif électronique oblige à de nombreuses opérations d'assemblage qui pèsent sur les coûts de fabrication du dispositif électronique ainsi que sur les coûts logistiques (stockage, transport vers le lieu de production, distribution jusqu'au poste d'assemblage) des sous-éléments.

Ces nombreux sous-éléments rendent également les dispositifs électroniques existant volumineux alors que les consommateurs recherchent des équipements de plus en plus compacts.

### OBJET DE L'INVENTION

Un but de l'invention est de fournir un dispositif électronique compact de fabrication plus économique.

### RESUME DE L'INVENTION

A cet effet, on prévoit, selon l'invention, un capot monobloc selon la revendication 1.
Au sens de la présente demande, le terme monobloc désigne un ensemble de composants solidarisés entre eux de manière à pouvoir être manipulés ensemble sans risque de désolidarisation des composants. Au sens de la présente demande, un capot est une coque externe du produit, une pièce visible sur le produit fini sans démontage et qui protège des composants internes de l'extérieur. Un capot apporte donc une protection mécanique (chocs, manipulations) et suivant les designs (sans trous), le capot peut apporter une protection contre les projections d'eau, la poussière et les chocs électriques/électrostatiques.

On obtient ainsi un élément unique regroupant une pluralité de fonctions ce qui réduit les flux logistiques et le volume d'opérations d'assemblage sur le lieu d'assemblage final de l'équipement électronique, et permet d'améliorer la compacité de l'équipement électronique final.

Avantageusement, l'antenne est reliée à des moyens de liaison électrique agencés pour pouvoir être raccordés au dispositif électronique.

Ceci améliore aussi la compacité du capot qui intègre les connecteurs et réduit également les temps d'assemblage.

Avantageusement encore, l'écran de blindage est relié à des moyens de liaison équipotentielle agencés pour pouvoir être raccordés au dispositif électronique.

Ceci améliore encore la compacité du capot qui intègre les connecteurs de la liaison équipotentielle et réduit également les temps d'assemblage.

Dans un but similaire, le capot comprend des moyens de liaison mécanique agencés pour permettre la fixation du capot au dispositif électronique.

Selon un mode particulier de réalisation, le capot comprend une structure métallique en un matériau comprenant du cuivre.

Avantageusement, l'antenne est noyée dans le matériau synthétique, ce qui offre une meilleure compacité du capot et améliore la qualité d'émission de l' antenne.

Selon un mode de réalisation préféré, les moyens de liaison électrique comprennent un contact de surface et/ou un contact comprenant un élément élastique.

Ceci permet de s'affranchir d'un tolérancement dimensionnel strict, ce qui réduit les coûts de fabrication, et assure un contact électrique pérenne. Préférentiellement, les moyens de liaison électrique comprennent un connecteur pour câble coaxial, idéalement de type UFL.

La mise en œuvre de connecteurs standards éprouvés permet une réduction des coûts d'approvisionnement et une amélioration de la fiabilité de la liaison électrique.

L'invention concerne également un procédé de fabrication d'un équipement électronique comprenant les étapes suivantes :
a) fabriquer un capot du type prévu ci-dessus ;
b) fabriquer un dispositif électronique ;
c) assembler le capot et le dispositif électronique.

D'autres caractéristiques et avantages de l'invention ressortiront à la lecture de la description qui suit d'un mode de réalisation particulier non limitatif de l'invention.

### BREVE DESCRIPTION DES DESSINS

Il sera fait référence aux dessins annexés, parmi lesquels :
- la figure 1 est une vue schématique, en perspective, d'un capot selon l'invention ;
- la figure 2 est une vue en perspective partiellement écorchée du capot de la figure 1 ;
- la figure 3 est une vue schématique en perspective d'une étape d'un procédé d'assemblage d'un équipement électronique selon l'invention ;
- la figure 4 est une vue en coupe longitudinale selon le plan IV-IV de l'équipement électronique de la figure 3 une fois assemblé.

### DESCRIPTION DETAILLEE DE L'INVENTION

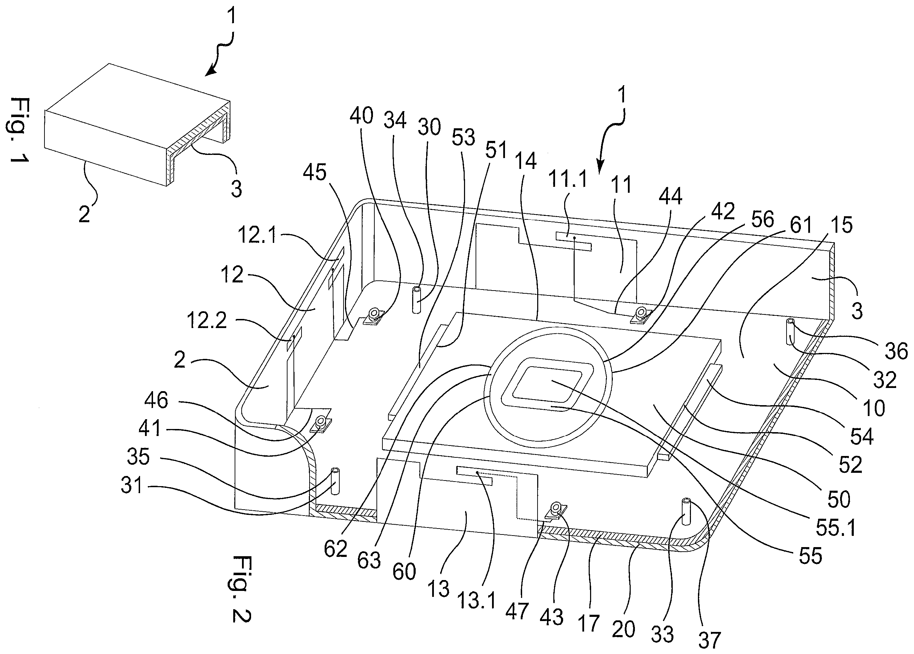

En référence aux figures 1 et 2, le capot monobloc selon l'invention, généralement désigné 1, est de forme sensiblement parallélépipédique et comprend une paroi supérieure et trois parois latérales contiguës de telle sorte que le boîtier a une face inférieure 2 ouverte et une face arrière 3 elle aussi ouverte.

Le capot 1 comporte une structure 10 d'antenne, en cuivre, de forme sensiblement rectangulaire. La structure 10 comprend en périphérie trois bords rabattus 11, 12 et 13 et une ouverture 14 de forme rectangulaire en son centre. Une surface interne 15 de la structure 10 délimite un logement 4 d'accueil d'un dispositif électronique.

Le capot 1 comprend également un dissipateur thermique 50 passif, de forme rectangulaire, logé dans l'ouverture 14 de la structure 10 pour avoir une face affleurant une surface externe 17 de la structure 10 au niveau de la paroi supérieure de la structure 10. Les plus petits cotés 51 et 52 du dissipateur thermique 50 comprennent des rebords 53 et 54 venant en saillie de l'ouverture 14 pour être fixés contre la structure 10 et assurer ainsi la solidarisation du dissipateur thermique 50 à la structure 10 et un contact électrique avec la structure 10. Une excroissance centrale 55 vient en saillie de la face 56 du dissipateur 50 opposée à celle affleurant la surface externe 17. L'excroissance centrale 55 est revêtue d'un pad thermique 55.1. Une bague 60 conductrice de section sensiblement carrée s'étend autour de l'excroissance 55 et est soudée par une face 61 sur le dissipateur thermique 50. La face 62 opposée à la face 61 comprend une bande de mousse 63 conductrice compressible.

Le capot 1 comprend également:
- une couche de matériau synthétique 20 -ici de l'ABS- surmoulée sur la structure 10 et la face affleurante du dissipateur thermique 50 pour recouvrir une surface externe 17 de la structure 10 opposée à la surface interne 15 de manière à former une paroi supérieure et trois parois latérales du capot ;
- quatre pions 30 à 33 de vissage venant en saillie de la paroi supérieure de la structure 10 du côté de la surface interne 15 et qui comprennent respectivement un taraudage 34 à 37;
- quatre connecteurs 40 à 43 femelles de type UFL reliés respectivement par des conducteurs 44 à 47 à des lames 11.1, 12.1, 12.2 et 13.1 taillées dans les bords rabattus 11 à 13. Les conducteurs 44 à 47 sont fixés à la structure 10 à l'aide de points de brasure.

Un procédé de fabrication d'un équipement électronique 100 va maintenant être décrit.

Selon une première phase, le capot 1 et un dispositif électronique sont fabriqués sur deux lignes de production distinctes qui se rejoignent pour permettre, dans une deuxième phase, l'assemblage du capot 1 au dispositif électronique.

Pour ce qui concerne le capot 1, les pions 30 à 33, les connecteurs 40 à 43, les conducteurs 44 à 47 sont brasés sur la structure 10 qui a été préalablement découpée et pliée pour former l'ouverture 14 et les bords rabattus 11 à 13. Le dissipateur thermique 50 est placé dans l'ouverture 14 et on dépose alors par surmoulage le matériau synthétique 20 sur l'ensemble. On obtient alors un capot 1 monobloc comprenant le dissipateur thermique 50, une antenne sous la forme de la structure 10 et une partie d'aspect formée du matériau synthétique 20. Comme il sera vu ultérieurement, la bague 60 réalise un écran de blindage. Le capot 1 peut ensuite être stocké en attente d'assemblage ultérieur.

La fabrication de la partie électronique est connue en elle-même et ne sera pas décrite plus en détail ici. Le dispositif électronique comprend ici une carte électronique 70 comprenant un processeur 71, une piste conductrice 72 circulaire de masse s'étendant autour du processeur 71, quatre connecteurs UFL 73 à 76 mâles ainsi que quatre perçages 77 à 80.

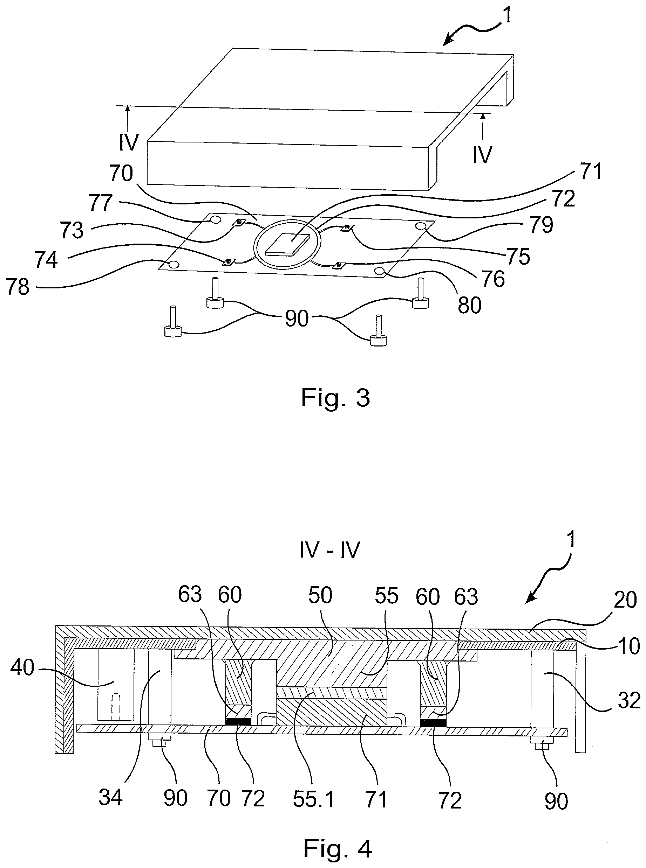

Selon la seconde phase du procédé représentée en figure 3, le dispositif électronique - est placé dans le logement 4. Des vis 90 engagées dans les perçages 77 à 80 sont engagées dans les taraudages 34 à 37 et vissées dans ceux-ci. Lors de la mise en position du dispositif électronique dans le logement 4 et du serrage des vis 90, les connecteurs UFL 73 à 76 mâles de la carte électronique 70 s'engagent dans les connecteurs UFL 40 à 43 femelles du capot 1, réalisant ainsi une connexion électrique entre la carte électronique 70 et la structure 10 d'antenne.

Comme visible en figure 4, une fois les vis 90 serrées, le pad thermique 55.1 du dissipateur thermique 50 est en contact avec la surface supérieure du processeur 71, assurant ainsi le transfert de la chaleur générée par le processeur 71 vers le dissipateur 50. Lors du serrage des vis 90, la mousse conductrice 63 de la bague 60 vient également en contact avec la piste conductrice 72 de la carte électronique 70, réalisant alors une liaison équipotentielle avec cette dernière. La bague 60 qui s'étend autour du processeur 71 réalise alors un blindage électromagnétique du processeur 71.

On obtient ainsi un équipement électronique 100 résultant d'une unique opération d'assemblage du capot 1 et de la carte électronique 70. Les vis 90 permettent une liaison mécanique de la carte électronique 70 et du capot 1 tout en assurant des connexions électriques durables et fiables entre d'un côté la structure 10, le dissipateur 50, le blindage 60 et d'un autre côté la carte électronique 70.

On note que le dispositif électronique a sa face inférieure formant la surface inférieure de l'équipement électronique et une face latérale formant une des surfaces latérales de l'équipement électronique tandis que le capot forme la surface supérieure et trois faces latérales de l'équipement électronique.

Bien entendu, l'invention n'est pas limitée aux modes de réalisation décrits mais englobe toute variante entrant dans le champ de l'invention telle que définie par les revendications.

En particulier :
- bien qu'ici le capot soit de forme parallélépipédique, l'invention s'applique également à d'autres formes de capot en fonction notamment d'une recherche esthétique. De la même façon, le capot peut disposer d'une seule face ouverte ou plus de deux faces ouvertes ;
- bien qu'ici la structure d'antenne soit en cuivre, l'invention s'applique également à d'autres matériau comme par exemple de l'acier étamé ou tout autre matériau adapté comprenant du cuivre ;
- bien qu'ici la couche de matériau synthétique soit une couche d'ABS déposée par surmoulage pour former les surfaces externes du capot, l'invention s'applique également à d'autres types de matériau synthétique électriquement isolant comme par exemple le polyamide ;
- bien qu'ici le matériau synthétique soit déposé sur une des faces de la structure d'antenne, l'invention s'applique également à une structure d'antenne noyée dans le matériau synthétique ;
- bien qu'ici le capot comprenne quatre pions de vissage, l'invention s'applique à d'autres moyens de liaison mécaniques agencés pour permettre la fixation du capot au dispositif électronique, comme par exemple le bouterollage, le collage ou le clippage ;
- bien qu'ici les conducteurs soient fixés à la structure d'antenne par brasage, l'invention s'applique également à d'autres moyens de fixation des conducteurs au capot comme par exemple le clippage, le collage ou le soudage ;
- bien qu'ici le dissipateur thermique soit fixé au capot par collage, l'invention s'applique également à d'autres moyens de solidarisation du dissipateur thermique au capot comme par exemple le clippage, le brasage ou le soudage ;
- bien qu'ici le capot comprenne une bague conductrice solidaire du dissipateur thermique, l'invention s'applique également à d'autres types d'écran de blindage comme par exemple un boitier métallique polygonal lié à l'antenne par des fixations isolées électriquement ;
- bien qu'ici l'écran de blindage soit relié au dispositif électronique par une bande de mousse conductrice compressible, l'invention s'applique également à d'autres moyens de liaison équipotentielle comme par exemple par vissage, clippage, liaison élastique, ressorts, lame métallique ou contact direct ;
- bien qu'ici le capot comprenne un pad thermique rapporté sur le dissipateur thermique, l'invention s'applique également à d'autres moyen de liaison thermique du dissipateur au dispositif électronique comme par exemple de la pâte thermique, un gel thermique, des mousses thermiques, une feuille de graphite ;
- bien qu'ici le capot comprenne des connecteurs UFL, l'invention s'applique également à d'autres types de moyens de liaison électrique comme par exemple un contact de surface ou encore un contact comprenant un élément élastique ;
- bien qu'ici le capot comprenne une structure d'antenne réalisée à partir d'une plaque métallique, l'invention s'applique également à d'autres types d'antennes comme par exemple un fil conducteur, une boucle de fil ou tout moyen adapté d'émission sans fil.

## Revendications

1. Capot (1) monobloc pour dispositif électronique (70), le capot (1) comprenant :
- une structure d'antenne (10) ;
- un dissipateur thermique (50) ayant une face affleurant une surface externe (17) de la structure d'antenne (10) ;
- un écran de blindage électromagnétique (60) ;
- un matériau synthétique (20) électriquement isolant formant des surfaces externes du capot (1), surmoulé sur la structure d'antenne (10) et la face affleurante du dissipateur thermique (50) pour recouvrir la surface externe (17) de la structure d'antenne (10) de manière à former une paroi supérieure et trois parois latérales du capot.

2. Capot (1) selon la revendication 1, dans lequel la structure d'antenne (10) est reliée à des moyens de liaison électrique (40, 41, 42, 43) agencés pour pouvoir être raccordés au dispositif électronique (70).

3. Capot (1) selon l'une quelconque des revendications précédentes, dans lequel l'écran de blindage électromagnétique (60) est relié à des moyens de liaison équipotentielle (63) agencés pour pouvoir être raccordés au dispositif électronique (70).

4. Capot (1) selon l'une quelconque des revendications précédentes, comprenant des moyens de liaison mécanique (30, 31, 32, 33) agencés pour permettre la fixation du capot (1) au dispositif électronique (70).

5. Capot (1) selon l'une quelconque des revendications précédentes, dans lequel la structure d'antenne (10) est en cuivre.

6. Capot (1) selon la revendication 5, dans lequel des conducteurs (44, 45, 46, 47) s'étendant entre la structure d'antenne (10) et les moyens de liaison électrique (40, 41, 42, 43) sont fixés à la structure d'antenne (10).

7. Capot (1) selon l'une quelconque des revendications précédentes, dans lequel la structure d'antenne (10) est noyée dans le matériau synthétique (20).

8. Capot (1) selon l'une quelconque des revendications précédentes, dans lequel l'écran de blindage électromagnétique (60) est une bague conductrice solidaire du dissipateur thermique (50).

9. Capot (1) selon la revendication 8, dans lequel le dissipateur thermique (50) comprend une excroissance centrale (55) en saillie d'une face (56) opposée à celle affleurant la surface externe (17) et la bague conductrice s'étend autour de l'excroissance (55) et est soudée par une face (61) sur le dissipateur thermique (50).

10. Capot (1) selon la revendication 9, dans lequel la bague conductrice a une face opposée (62) qui comprend une bande de mousse (63) conductrice compressible.

11. Capot (1) selon la revendication 2, dans lequel les moyens de liaison électrique (40, 41, 42, 43) comprennent un contact de surface et/ou un contact comprenant un élément élastique.

12. Capot (1) selon la revendication 2, dans lequel les moyens de liaison électrique (40, 41, 42, 43) comprennent un connecteur (40, 41, 42, 43) pour câble coaxial.

13. Capot (1) selon la revendication 12, dans lequel le connecteur (40, 41, 42, 43) pour câble coaxial est de type UFL.

14. Capot (1) selon la revendication 3, dans lequel les moyens de liaison équipotentielle (63) au dispositif électronique (70) comprennent une mousse conductrice compressible (63).

15. Capot (1) la revendication 4, dans lequel les moyens de liaison mécanique (30, 31, 32, 33) comprennent au moins un filetage (34, 35, 36, 37) destiné à accueillir une vis (90).

16. Procédé de fabrication d'un équipement électronique (100) comprenant les étapes suivantes :
a) fabriquer un capot (1) selon l'une quelconque des revendications précédentes ;
b) présenter un dispositif électronique (70) ;
c) assembler le capot (1) et le dispositif électronique (70).

## Patentansprüche

1. Einteilige Abdeckung (1) für eine elektronische Vorrichtung (70), wobei die Abdeckung (1) umfasst:
- eine Antennenstruktur (10);
- einen Kühlkörper (50) mit einer Seite, die bündig mit einer Außenfläche (17) der Antennenstruktur (10) abschließt;
- eine elektromagnetische Abschirmung (60);
- einen elektrisch isolierenden Kunststoff (20), welcher Außenflächen der Abdeckung (1) bildet und mit welchem die Antennenstruktur (10) und die bündige Seite des Kühlkörpers (50) derart umspritzt sind, dass die Außenfläche (17) der Antennenstruktur (10) unter Ausbildung einer oberen Wand und dreier Seitenwände der Abdeckung davon bedeckt ist.

2. Abdeckung (1) nach Anspruch 1, wobei die Antennenstruktur (10) mit elektrischen Verbindungsmitteln (40, 41, 42, 43) verbunden ist, welche dafür ausgelegt sind, an die elektronische Vorrichtung (70) angeschlossen zu werden.

3. Abdeckung (1) nach einem der vorhergehenden Ansprüche, wobei die elektromagnetische Abschirmung (60) mit Potentialausgleichsmitteln (63) verbunden ist, welche dafür ausgelegt sind, an die elektronische Vorrichtung (70) angeschlossen zu werden.

4. Abdeckung (1) nach einem der vorhergehenden Ansprüche, umfassend mechanische Verbindungsmittel (30, 31, 32, 33), welche dafür ausgelegt sind, die Abdeckung (1) an der elektronischen Vorrichtung (70) befestigbar zu machen.

5. Abdeckung (1) nach einem der vorhergehenden Ansprüche, wobei die Antennenstruktur (10) aus Kupfer gefertigt ist.

6. Abdeckung (1) nach Anspruch 5, wobei Leiter (44, 45, 46, 47), die sich zwischen der Antennenstruktur (10) und den elektrischen Verbindungsmitteln (40, 41, 42, 43) erstrecken, an der Antennenstruktur (10) befestigt sind.

7. Abdeckung (1) nach einem der vorhergehenden Ansprüche, wobei die Antennenstruktur (10) in den Kunststoff (20) eingebettet ist.

8. Abdeckung (1) nach einem der vorhergehenden Ansprüche, wobei es sich bei der elektromagnetischen Abschirmung (60) um einen einstückig mit dem Kühlkörper (50) ausgebildeten leitenden Ring handelt.

9. Abdeckung (1) nach Anspruch 8, wobei der Kühlkörper (50) eine zentrale Erhebung (55) umfasst, die über eine Seite (56) vorsteht, welche jener Seite entgegengesetzt ist, die mit der Außenfläche (17) bündig abschließt, und wobei sich der leitende Ring um die Erhebung (55) herum erstreckt und mit einer Seite (61) auf dem Kühlkörper (50) festgeschweißt ist.

10. Abdeckung (1) nach Anspruch 9, wobei der leitende Ring eine entgegengesetzte Seite (62) aufweist, die einen komprimierbaren leitfähigen Schaumstoffstreifen (63) umfasst.

11. Abdeckung (1) nach Anspruch 2, wobei die elektrischen Verbindungsmittel (40, 41, 42, 43) einen Oberflächenkontakt und/oder einen Kontakt mit einem Federelement umfassen.

12. Abdeckung (1) nach Anspruch 2, wobei die elektrischen Verbindungsmittel (40, 41, 42, 43) einen Steckverbinder (40, 41, 42, 43) für Koaxialkabel umfassen.

13. Abdeckung (1) nach Anspruch 12, wobei es sich bei dem Steckverbinder (40, 41, 42, 43) für Koaxialkabel um einen UFL-Steckverbinder handelt.

14. Abdeckung (1) nach Anspruch 3, wobei die Potentialausgleichsmittel (63) zur Anbindung an die elektronische Vorrichtung (70) einen komprimierbaren leitfähigen Schaumstoff (63) umfassen.

15. Abdeckung (1) nach Anspruch 4, wobei die mechanischen Verbindungsmittel (30, 31, 32, 33) zumindest ein Gewinde (34, 35, 36, 37) zur Aufnahme einer Schraube (90) umfassen.

16. Verfahren zur Herstellung einer elektronischen Ausrüstung (100), umfassend die Schritte, dass:
a) eine Abdeckung (1) nach einem der vorhergehenden Ansprüche hergestellt wird;
b) eine elektronische Vorrichtung (70) bereitgestellt wird;
c) die Abdeckung (1) und die elektronische Vorrichtung (70) zusammengebaut werden.

## Claims

1. Single-piece cover (1) for an electronic device (70), the cover (1) comprising:
· a structure of antenna (10);
· a heatsink (50) having a face flush with an external surface (17) of the structure of antenna (10);
· an electromagnetic shielding screen (60);
· an electrically-insulating synthetic material (20) forming outside surfaces of the cover (1), overmolded on the structure of antenna and the flush face of the heatsink (50) for covering the external surface (17) of the structure of antenna (10) in such a manner to form a top surface and three lateral faces of the cover.

2. Cover (1) according to claim 1, wherein the antenna (10) is connected to electrical connection means (40, 41, 42, 43) arranged so as to be capable of being connected to the electronic device (70).

3. Cover (1) according to either preceding claim, wherein the shielding screen (60) is connected to equipotential bonding means (63) arranged so as to be capable of being connected to the electronic device (70).

4. Cover (1) according to any preceding claim, including mechanical connection means (30, 31, 32, 33) arranged so as to enable the cover (1) to be fastened to the electronic device (70).

5. Cover (1) according to any preceding claim, wherein the structure of antenna (10) cis made of copper.

6. Cover (1) according to claim 5, wherein the conductors (44, 45, 46, 47) extending between the antenna (10) and the electrical connection means (40, 41, 42, 43) are fastened to the metal structure (10).

7. Cover (1) according to any preceding claim, wherein the cover (10) is embedded in the synthetic material (20).

8. Cover (1) according to any preceding claim, wherein the electromagnetic shielding screen (60) is conductive ring secured to the heatsink (50).

9. Cover (1) according to any preceding claim, wherein the heatsink (50) comprising a central protrusion (55) protruding from a face (56) opposed to the face flush with the external surface (17) and the conductive ring extends around the protrusion (55) and has a face (61) welded on the heatsink (50).

10. Cover (1) according to claim 9, wherein the conductive ring has an opposite face (62) comprising a foamed band (63) that is conductive and compressible.

11. Cover (1) according to claim 2, wherein the electrical connection means (40, 41, 42, 43) comprise a surface contact and/or a contact including a resilient element.

12. Cover (1) according to claim 2, wherein the electrical connection means (40, 41, 42, 43) comprise a coaxial cable connector (40, 41, 42, 43).

13. Cover (1) according to claim 11, wherein the coaxial cable connector (40, 41, 42, 43) is of the UFL type.

14. Cover (1) according to claim 3, wherein the equipotential bonding means (63) for bonding with the electronic device (70) comprise a compressible conductive foam (63).

15. Cover (1) according to claim 4, wherein the mechanical connection means (30, 31, 32, 33) comprise at least one threaded hole (34, 35, 36, 37) designed for receiving a screw (90).

16. Method of manufacturing electronic equipment (100) comprising the following steps:
a) manufacturing a cover (1) according to any preceding claim;
b) presenting an electronic device (70);
c) assembling the cover (1) and the electronic device (70) together.
